**Europäisches Patentamt**

**European Patent Office**

**Office européen des brevets**

(11) Publication number: **0 179 326**
**A1**

(12) # EUROPEAN PATENT APPLICATION

(21) Application number: **85112538.5**

(22) Date of filing: **03.10.85**

(51) Int. Cl.⁴: **H 05 K 9/00**
**D 03 D 15/00**

(30) Priority: **05.10.84 JP 208199/84**

(43) Date of publication of application:
**30.04.86 Bulletin 86/18**

(84) Designated Contracting States:
**DE FR GB**

(71) Applicant: **HITACHI, LTD.**
**6, Kanda Surugadai 4-chome Chiyoda-ku**
**Tokyo 100(JP)**

(72) Inventor: **Akiba, Yutaka**
**936-6, Takakura**
**Fujisawa-shi(JP)**

(72) Inventor: **Hirota, Kazuo**
**910-911, Hamanogo**
**Chigasaki-shi(JP)**

(72) Inventor: **Ishi, Ichiro**
**Furora Katsuradai 14-201 2069-1, Kamigocho**
**Totsuka-ku Yokohama(JP)**

(74) Representative: **Altenburg, Udo, Dipl.-Phys. et al,**
**Patent- und Rechtsanwälte**
**Bardehle-Pagenberg-Dost-Altenburg-Frohwitter &**
**Partner Postfach 86 06 20**
**D-8000 München 86(DE)**

(54) **Plate-like woven-wire structure, woven-wire solid plate, and magnetic bubble memory device using the woven-wire structure or solid plate.**

(57) A plate-like woven-wire structure comprises which are woven orthogonally to each other into a platelike woven structure such that the element wires successively and periodically distribute at all possible positions between opposite surfaces of said plate-like woven structure in a direction of thickness thereof along a weaving direction of the element wires. Each element wire includes at least one metal core (1) an outer periphery of which is covered with a material having a higher resistivity than the metal core material. A woven-wire solid plate (7, 17, 25) is formed by press-forming the plate-like woven-wire structure. A magnetic field confining conductive case (35) of a magnetic bubble memory device can be formed by the plate-like woven-wire structure or woven-wire solid plate.

FIG. I

PLATE-LIKE WOVEN-WIRE STRUCTURE, WOVEN-WIRE SOLID PLATE,

AND MAGNETIC BUBBLE MEMORY DEVICE USING THE WOVEN-WIRE

STRUCTURE OR SOLID PLATE

## 1 BACKGROUND OF THE INVENTION

The present invention relates to a plate-like woven-wire structure and a woven-wire solid plate suitable for use as a magnetic shielding member, and to a magnetic bubble memory device using such woven-wire structure or solid plate in a rotating magnetic filed confining case (conductive case).

In a prior art magnetic bubble memory device, in order to confine a driving magnetic field (rotating magnetic field), a drive coil wound on a ferrite core is completely surrounded by a case mode by electrically conductive plates as shown in U.S. Patent No. 4,165,535. The rotating magnetic field is confined in the conductive case by utilizing an eddy current generated by a change of the rotating magnetic field penetrating into the conductive plate.

Such a conductive case has a closed case structure which forms an efficient loop to the eddy current in order to reduce a power consumption of the device and reduce a resistance of the driving coil. In order to further reduce the power consumption, the eddy current which is necessary to confine the rotating magnetic field may be reduced by using a sufficiently larger conductive case than the driving coil, but this

0179326

causes a problem of increase of a rize of the device and a reactive power. A material of the conductive case is copper or aluminum. (See JP-B 57-19517.) In the U.S. Patent No. 4,165,535, the conductive case is made of an electric conductor having a sufficient thickness to reflect the rotating magnetic field on a surface thereof. The prior art conductive case for confining the rotating magnetic field is made of a single material.

The conductive case for confining the periodically changing rotating magnetic field has a skin effect characterized by a skin depth $\delta = \sqrt{2/\omega\sigma\mu}$ where $\omega$ (=$2\pi f$) is an angular frequency of the rotating magnetic field, $\sigma$ is a conductivity of the conductor and $\mu$ is a permeability of the conductor. The higher the driving frequency is, the larger is the influence by the skin effect. As the driving frequency $f$ increases, the skin depth $\delta$ decreases, an effective thickness of the conductive case decreases and a power consumption increases. Accordingly, so far as the prior art conductive case is used, the increase of the power consumption in a high frequency drive pores an essential problem. In a typical example of the prior art conductive case, a copper plate having a thickness of several hundreds of microns is used. A skin depth at a driving frequency of 200 KHz is approximately 145 $\mu$m.

Accordingly, the eddy current necessary to confine the rotating magnetic field is concentrated only to a limited thickness area of the conductive case. Thus, a resistance in a current path increases, the power consumption of the drive coil increases and the conductive case is heated to a high temperature.

On the other hand, since a high integration density and a high speed are essential in a magnetic bubble memory, the increase of the driving frequency due to a large capacity is innevitable. This tends to conflict to the reduction of the power consumption.

The conductive case of the prior art magnetic bubble memory device makes the high speed of the magnetic bubble memory essemtially difficult in view of the power consumption.

Those problems are common in the art where a high driving frequency is used to generate a magnetic field and a conductive plate is used to shield a magnetic field. Accordingly, a magnetic shielding conductor structure which is free from the influence of the skin effect or at least reduces the influence is desired.

SUMMARY OF THE INVENTION

It is an object of the present invention to provide a plate-like woven-wire structure which is suitable for use as a magnetic shielding mamber and which is free from an influence of a skin effect.

It is another object of the present invention to provide a woven-wire solid plate which is suitable for use as a magnetic shielding member and which is free from an influence of a skin effect. The solid plate is manufactured by press-forming a plate-like woven-wire structure.

It is other object of the present invention to provide a magnetic bubble memory device having a magnetic field confining conductive case which is free from an influence of a skin effect so that a power consumption of a high speed driving coil is reduced. The conductive case is formed by a plate-like woven-wire structure or a woven-wire solid plate.

In the present invention, it has been noticed that a structure which is free from the influence of the skin effect is attained by a structure which allows a uniform current to flow thicknesswise.

A plurality of current paths are provided by arranging an insulative layer or a layer having a low conductivity $\sigma$ in a conductor, with structual arrangement of the current paths in any direction being periodically uniform so that a uniform current (eddy current) flows in each of the current paths.

According to one aspect of the present invention, there is provided a plate-like woven-wire structure comprising: first and second groups of element wires each including at least one metal core, an outer periphery of the metal core being covered with a coating film of a material having a higher resistivity than a material of the metal core; said first and second groups of element wires being woven orthogonally to each other into a plate-like woven structure such that the element wires successively and periodically distribute at all possible positions between opposite surfaces of said plate-like woven structure in a direction of thickness thereof along a weaving direction of the element wires.

According to another aspect of the present invention, there is provided a woven-wire solid plate comprising: first and second groups of element wires each including at least one metal core, an outer periphery of the metal core being covered with a coating film of a material having a higher resistivity than a material of the metal core; said first and second groups of element wires being woven orthogonally to each other into a plate-like woven structure such that the element wires successively and periodically distribute at all possible positions between opposite surfaces of said plate-like woven structure in a direction of thickness thereof along a weaving direction of the element wires, said plate-like woven structure being press-formed into a solid plate having substantially flat and continuous opposing surfaces and having the element wires closely

0179326

packed in any thicknesswise section.

According to a further aspect of the present invention, there is provided a magnetic bubble memory device comprising: a parallelpiped core made of a magnetic material having windings wound at four positions such that opposing windings are parallel to each other; a magnetic bubble memory chip arranged in a space defined by said core; a wiring board on which said chip is mounted; a shielding conductive case surrounding said core, said chip and said wiring board, said shielding conductive case being formed by an woven structure of first and second groups of element wires each including at least one metal core, an outer periphery of the metal core 1 being covered with a coating film of a material having a higher resistivity than a material of the metal core; said first and second groups of element wires being woven orthogonally to each other into a plate-like woven structure such that the element wires successively and periodically distribute at all possible positions between opposite surfaces of said plate-like woven structure in a direction of thickness thereof along a weaving direction of the element wires.

BRIEF DESCRIPTION OF THE DRAWINGS

Figs. 1, 2 and 3 are perspective views, partially cut away, of three embodiment of a woven-wire solid plate of the present invention;

Figs. 4 to 7 are sectional views of element wires used in the present invention;

Fig. 8 is a perspective view of one embodiment of a plate-like woven-wire structure of the present invention;

Fig. 9 is a sectional view taken along line IX-IX of Fig. 8;

Figs. 10-13 show weaving methods in forming one, two, three and five-layer plate-like woven-wire structures;

Fig. 14 is a perspective view of a drive unit used to explain an embodiment of a magnetic bubble memory device of the present invention;

Fig. 15 is a sectional view taken along line XV-XV of Fig. 14;

Fig. 16 is a characteristic curve showing a relationship between an eddy current density J and a plate thickness t in a section A-A;

Fig. 17 is a characteristic curve showing a relationship between a resistance R and the plate thickness t;

Fig. 18 is a characteristic curve showing a relationship between the resistance R and a driving frequency f; and

Fig. 19 is a sectional view of a woven-wire solid plate for illustrating formation of a current

- 8 -

0179326

path.

## DESCRIPTION OF THE PREFERRED EMBODIMENTS

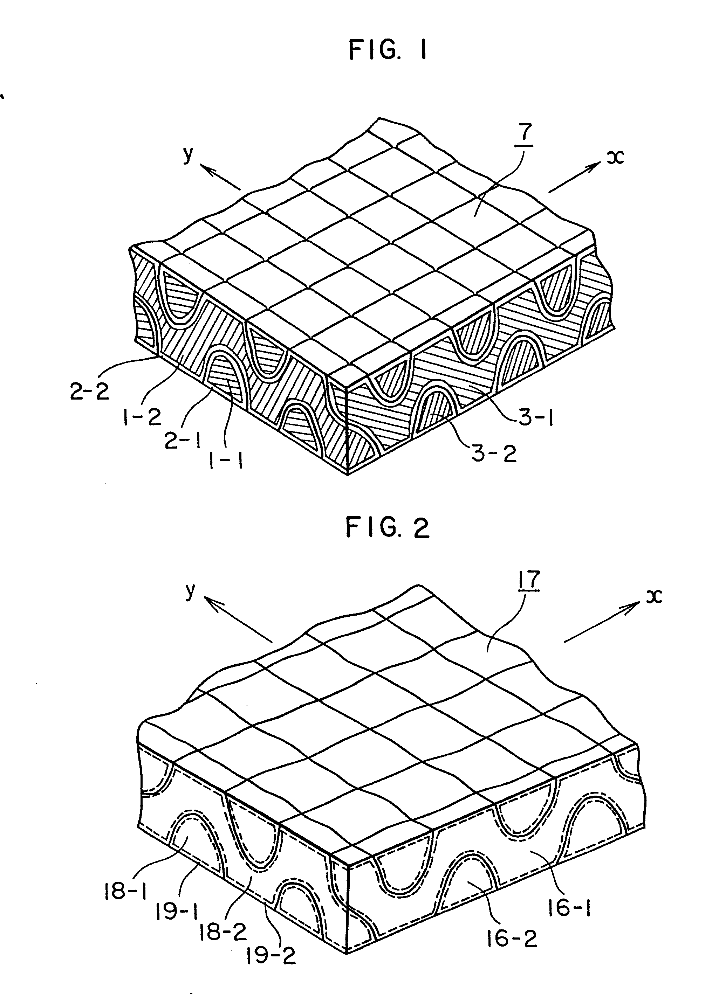

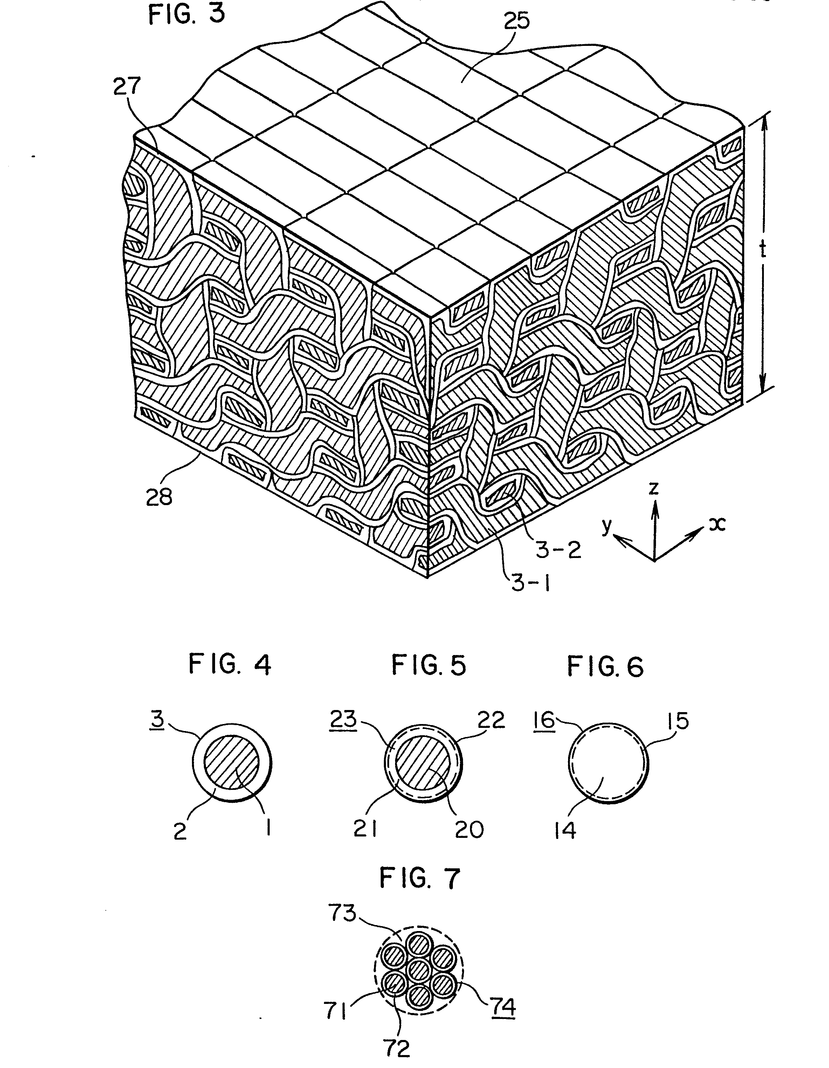

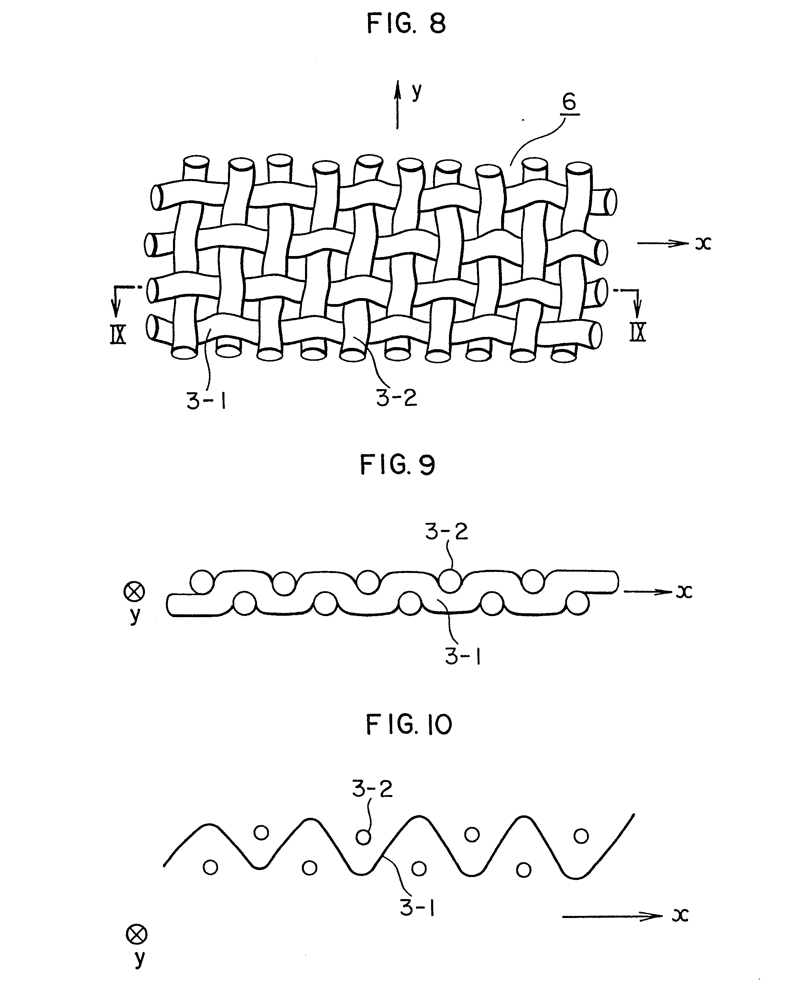

Fig. 1 is a perspective view of a first embodiment of a woven-wire solid plate of the present invention. In order to form a woven-wire solid plate 7 shown in Fig. 1, element wires 3 each having a metal coating film 2 having a large resistivity ρ formed around a copper core 1 as shown in Fig. 4 are prepared. The metal coating film 2 may be made of aluminum or tin. The element wire 3 may have a dimension of 200 μm in a diameter of the copper core 1 and 20 μm in a thickness of the aluminum coating film 2. The element wire may be easily formed by continuously drawing a hollow aluminum tube having a copper cylinder inserted therein. Then, as shown in Fig. 8, a first group of element wires 3-1 and a second group of element wires 3-2 are woven in one plane orthogonally to each other such that the element wires 3-1 extend in an x-direction and the element wires 3-2 extend in a y-direcrtion to form a plate-like woven-wire structure 6. Fig. 9 shows a sectional view taken along line IX-IX of Fig. 8. The woven-wire structure 6 is then press-formed so that a solid plate 7 having substantially flat and continuous top and bottom surfaces and having the element wires 3 closely packed thicknesswise as shown in Fig. 1 is formed.

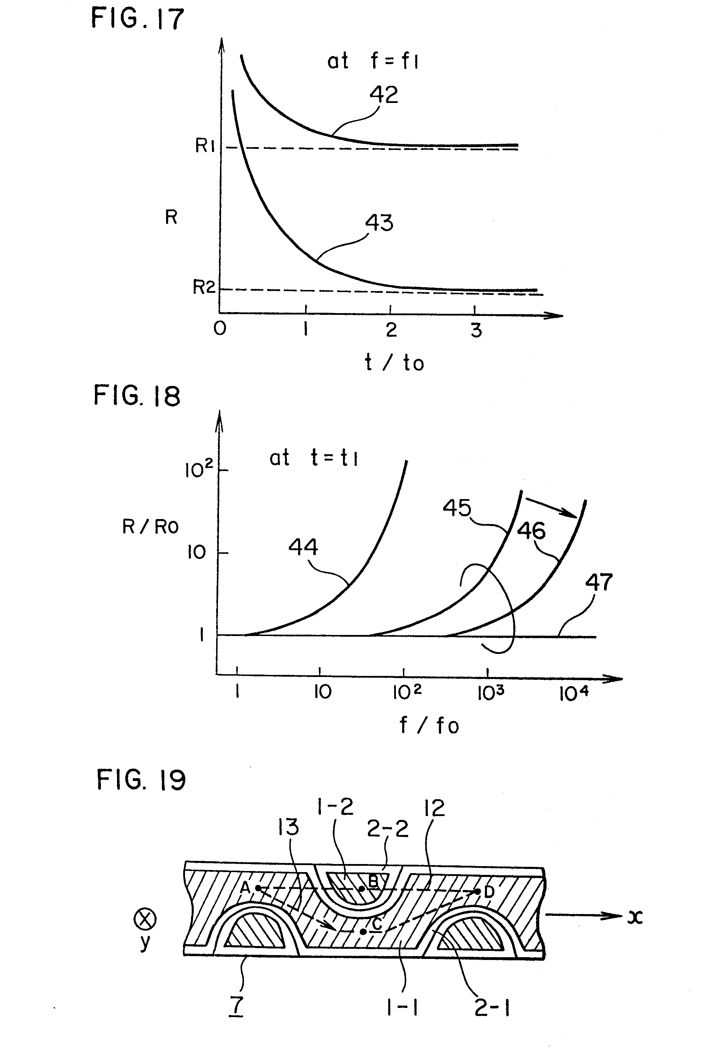

Referring to Fig. 19 which shows a sectional view the plate 7, a reason why the copper core 1 can be secured as the current path by the metal coating film 2 of the element wire 3 of the solid plate 7. Considering the currents flowing in the x-direction, that is, the currents flowing through two current paths ABD 12 and ACD 13, a substantial current flows through the current paths 13 along the core 1-1 because the current path 12 includes metal coating films 2-1 and 2-2 having larger resistivities than the copper cores 1-1 and 1-2. In the arrangement of Fig. 1, the diameter of the copper core 1-1 is preferably equal to or smaller than twice of the skin depth $\delta$ from the standpoint of the prevention of the skin effect in the element wire 3. For example, when the driving frequency is 200 KHz, the skin depth $\delta$ of the copper is approximately 145 $\mu$m and the diameter of the copper core is preferably equal to or smaller than approximately 300 $\mu$m. In order to eliminate the influence of the skin effect in the thickness direction of the solid plate 7, the solid plate 7 is constructed such that positions of the element wires 3 in the thickness direction distribute from the top surface to the bottom surface of the plate 7 in the weaving direction of the element wires and the element wires 3 appear in the plate 7 at a uniform probability. That is, the element wires 3 successively and periodically occupy all possible positions along the weaving direction of the element wires between the top and bottom surfaces of the plate 7 in the thickness direction thereof. Instead of the metal coating 2 of the element wire 3 shown in Fig. 4, an insulative coating film such as enamel resin may be used.

Fig. 2 shows a second embodiment of the woven-wire solid plate of the present invention. An element wire 16 is formed by an aluminum core 14 having an alumina coating 15 coated thereon as an insulative coating film as shown in Fig. 6. A first group of element wires 16-1 and a second group of element wires 16-2 are woven in one plane to form a woven-wire structure in the same manner as that shown in Fig. 8, and it is press-formed into a solid plate 17. The element wire 16 can easily form a current path because it has the insulative alumina coating film 15. Further, since the element wire 16 uses the easily deformable aluminum core 14, the manufacture of the solid plate 17 is facilitated.

The element wire is not limited to that shown in Fig. 4 or 6. For example, as shown in Fig. 5, an element wire 23 may be formed by forming an aluminum layer 21 around a copper core 20 and forming an alumina coating film 22 around the aluminum layer 21. Instead of the element wire having a single metal core shown in Figs. 4-6, the element wire may be a litz wire 74, as shown in Fig. 7, including a plurality of separately insulated thin metal cores 71 called strands woven together so that each strand successively takes up all possible positions in the cross section of the entire conductor. Numeral 72 denotes an insulative coating formed around the metal core 71.  The outer periphery of the litz wire 74 is coated by an insulative material 72 as a whole.  An insulative coating 73 shown by a chain line may be further formed thereon.  The metal core 7 masy be aluminum, the coating 72 may be alumina and the coating 73 may be enamel resin.

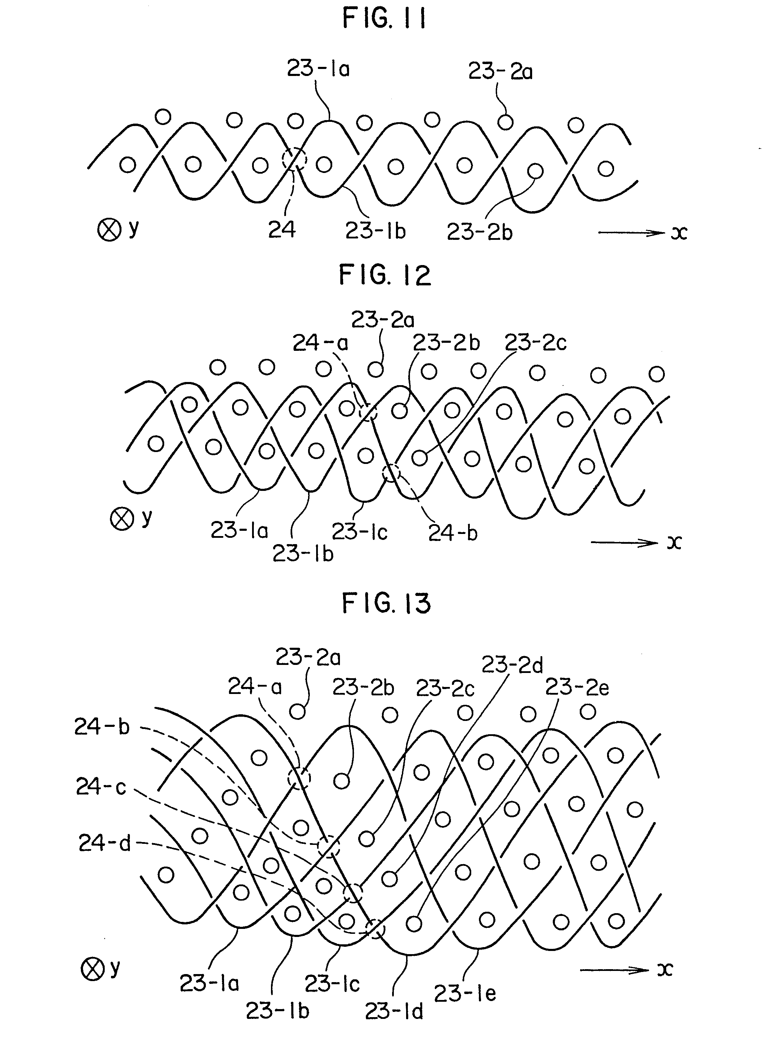

In the embodiments of the woven-wire solid plate described above, the element wires are woven orthogonally in one plane.  Fig. 10 shows a simplified cross section structure drawn based on Fig. 9.  It shows the one-layer woven structure 6 of Fig. 8 and shows a positional relationship between the element wires 3-1 woven in the x-direction and the element wires 3-2 woven in the y-direction.  The woven-wire solid plate may be formed by a multi-layer plate-like woven-wire structure. Fig. 11 shows a simplified sectional view of a two-layer plate-like woven-wire structure.  Two element wires 23-1a and 23-1b are woven in the x-direction such that they have a uniform positional relationship with the y-direction at crosspoints 24, and two element wires 23-2a and 23-2b are similarly woven in the y-direction.  The element wires 23 used are those shown in Fig. 5 although they may be the element wires 3, 16 or 74 shown in Figs. 4, 6 or 7.

Fig. 12 shows a simplified sectional view of a three-layer plate-like woven-wire structure, and Fig. 13 shows a simplified sectional view of a five-layer plate-like woven-wire structure. Five element wires 23-1a, 23-1b, 23-1c, 23-1d and 23-1e are woven in the x-direction such that they have a uniform positional relationship with the y-direction at four crosspoints 24-a, 24-b, 24-c and 24-d, and five element wires 23-2a, 23-2b, 23-2c, 23-2d and 23-2e are similarly woven in the y-direction. A four-layer or six-layer woven-wire structure may be similarly formed.

Fig. 3 shows a third embodiment of the woven-wire solid plate of the present invention. It shows a solid plate 25 having flat surfaces 27 and 28 formed by press-forming a five-layer plate-like woven-wire structure. The element wires 3 used are those shown in Fig. 4 although they may be the element wires 23 or 16 shown in Fig. 5 or 6. In the present embodiment, the element wires 3 are woven in the x-direction and the y-direction in five layers in the manner shown in Fig. 13. The thicknesswise (z-direction) positions of the element wires 3-1 (3-2) uniformly distribute from the top surface 27 to the bottom surface 28 with respect to the weaving direction of the element wires 3-1 (3-2) so that a uniform current flows through each of the element wires 3-1 (3-2) to prevent the skin effect of the currents flowing in the solid plate 25. The diameter of the element wire 3 is large enough to eliminate the influence of the skin effect to the element wire 3. In the present embodiment, since the skin effect of the five-layer solid plate 25 is prevented, the thickness t of the plate 25 can be increased so that electical resistances of the plate 25 in the x-direction and y-direction can be substantially reduced. For a given diameter of the element wire 3, the plate thickness can be increased in the multi-layer solid plate so that the electrical resistance can be substantially reduced. In the single-layer solid plate woven by the litz wires 74 as shown in Fig. 7, the mumber of thin metal cores 71 which form the element wire 74 may be increased to obtain a similar effect to that attained in a multi-layer solid plate woven by the element wires of single metal core.

The woven-wire solid plate described above can reduce or substantially eliminate the influence of the skin effect and can be effectively used as a magnetic shielding member. Further, the plate-like woven-wire structure used to form the woven-wire solid plates can also be used as the magnetic shielding members. When the plate-like woven-wire structure is directly used as the magnetic shielding member, it is advantageous to weave the element wires as closely as possible in order to minimize gaps between the element wires in the woven structure so that an effective volume for current flow increases. For example, Fig. 8 shows one embodiment of the plate-like woven-wire structure of the present invention. Where the element wires 3-1 in the x-direction and the element wires 3-2 in the y-direction are woven most closely in one layer, a percentage of voids as viewed thicknesswise (z-direction) of the plate-like woven structure is approximately 25% (one quarter). If the element wires in the x-direction or y-direction are woven most closely with two adjacent element wires being closely arranged together, the percentage of the voids is approximately 17% (one sixth), and if the element wires in the x-direction and y-direction are woven most closely with two adjacent element wires being closely arranged together, the percentage of the voids is approximately 11% (one ninth).

In either the plate-like woven-structure or the woven-wire solid plate, in order to eliminate the influence of the skin effect, it is essential that the element wires are sequentially and periodically arranged along the weaving direction at all possible posiitions between the top and bottom surfaces in the thickness direction of the woven structure.

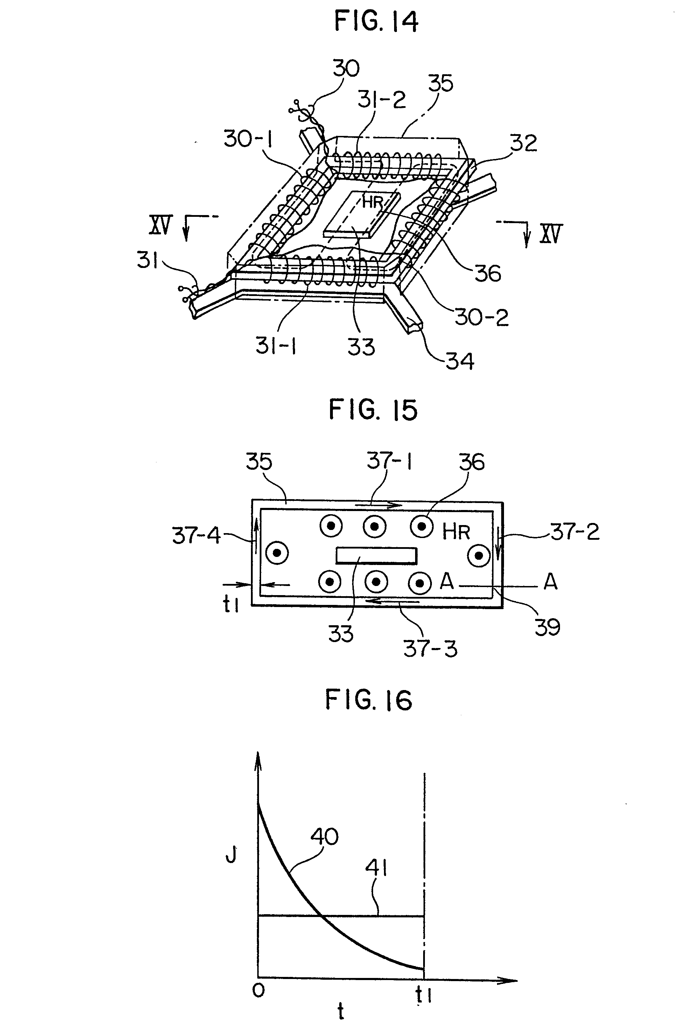

Fig. 14 shows a perspective view of a drive unit for illustrating one embodiment of a magnetic bubble memory device of the present invention. It comprises a rectangular core 32 of magnetic material having windings wound at four positions such that opposing windings 30-1 and 30-2, and 31-1 and 31-2 are parallel to each other, a magnetic bubble memory chip 33 placed in an area defined by the core 32 and a wiring board 34 on which the chip 33 is mounted, all these elements being housed in a conductive case 35 (shown by chain lines).

A broken line arrow 36 shows a momentary rotating magnetic field $H_R$ created by the windings 30 and 31. As shown in Fig. 15 which is a sectional view taken along a line XV-XV of Fig. 14 and in which the core 32, winding 30 and wiring board 34 are omitted, eddy currents (inductive currents) which form closed loops flow in directions of arrows 37-1, 37-2, 37-3 and 37-4 in the conductive case 35 which confines the rotating magnetic field. As the rotating magnetic field driving frequency f increases to obtain a higher speed of the magnetic bubble memory device, the eddy currents 37 are influenced by the skin effect and the current distiribution is uneven if the conventional conductor case made of copper plates or aluminum plate having a plate thickness of $t_1$ is used. In the A-A section of Fig. 15, a point 39 in the conductive case 35 is assumed to be an origin point and the plate thickness t is measured in the outward direction. Thus, an eddy current density distribution J is shown by 40 in Fig. 16. With such a distribution 40, an effective sectional area, that is, an effective plate thickness $t_1$ decreases and the resistance in the current paths increases. Secondly, for a given total eddy current $I_T$ necessary to confine the rotating magnetic field, the effective sectional area of the current paths decreases, the eddy current density distribution J increases, a loss in the conductive case 35 increases and a power consumption increases.

The eddy current density distribution 41 shown in Fig. 16 is for the woven-wire solid plate used as the conductive case 35. Since the eddy currents are not influenced by the skin effect, the distribution 41 is uniform even in a high drive frequency range. Accordingly, the effective plate thickness $t_1$ in the eddy current path is not reduced and the thickness $t_1$ of the woven-wire solid plate can be increased. As a result, the resistance of the current paths can be reduced inversely proportionally to the thickness $t_1$. Thus, since the thickness $t_1$ of the current paths does not change relative to the constant total eddy current $I_T$ necessary to confine the rotating magnetic field, the eddy current density J is constant, and the reduction of the loss in the conductive case, that is, the reduction of the power consumption of the magnetic bubble memory device, which had been difficult to attain in the prior art, can be readily and significantly achieved.

Fig. 17 shows a relationship between the resistance R of the drive unit of the magnetic bubble memory shown in Fig. 14 and the thickness t of the conductive case 35. At a given frequency $f_1$, a characteristic for a prior art metal plate is shown by a curve 42, and a characteristic for the woven-wire solid plate of the present invention is shown by a curve 43.

The characteristic curve 42 shows that the loss resistance R does not go below a constant value $R_1$ even if the plate thickness t is large due to the influence of the skin effect. On the other hand, in the characteristic curve 43, the resistance R decreases inversely proportionally to the thickness t to approach a constant value $R_2$ which is a loss of the winding 30 (31) in Fig. 14 and has no direct relation to the conductive case 35.

Fig. 18 shows a relationship between the resistance R and the driving frequency f of the drive unit of the magnetic bubble memory device shown in Fig. 14. $R_0$ represents a resistance at a low frequency $(< f_0)$. It is not substantially affected by the skin effect.

A characteristic for the prior art metal plate having the thickness $t_1$ is shown by a curve 44, and characteristics for the woven-wire solid plate of the present invention are shown by curves 45, 46 and 47. The characteristic curve 44 rises fast because of the influence of the skin effect as the driving frequency f increases.  The characteristic curve 45 rises lately compared to the curve 44 but exhibits a similar tendency.  This is because the diameter of the element wires used in the woven-wire solid plate is within a range affected by the skin effect as the driving frequency increasess.  Accordingly, when the multi-layer solid plate having smaller diameter element wires is used, the rise of the resistance R can be delayed as shown by the chararacteristic curve 46.  In the characteristic curve 47, the diameter of the element wires is sufficiently reduced to prevent the skin effect up to the required driving frequency ($f/f_0 > 10^4$).  The characteristics 46 and 47 can be attained in the single-layer solid plate which uses the litz wires as shown in Fig. 7.

As seen from the above description, the woven-wire solid plate of the present invention provides the conductive case necessary to reduce the power consumption of the high speed driving coil in the magnetic bubble memory device.  The plate-like woven-wire structure disclosed herein also can reduce or eliminate the influence of the skin effect and hence can be used as the conductive case of the magnetic bubble memory devices.

When the closed conductive case 35 is formed using a woven-wire solid plate, the case 35 will have a plurality of locations where ends of the solid plate are connected with each other. For example, at the left and lower corner of the case 35 shown in Fig. 15, the inner surface of the lower end of the vertical case portion will be connected with the side face of the left end of the horizontal case portion. Such connection may be made by a well-known technique such as soldering, thermocompression bonding or welding. The soldering is made with a sufficiently small thickness as much as 100 to 300 μm. The connection may be made with a thin metal foil interposed between ends of the solid plate to be connected with each other. The same also holds for the case where the case 35 is formed using a plate-like woven-wire structure.

CLAIMS

1.      A plate-like woven-wire structure comprising:

first and second groups of element wires (3-1, 3-2) each including at least one metal core (1), an outer periphery of the metal core being covered with a coating film (2) of a material hoving a higher resistivity than a material of the metal core;

said first and second groups of element wires being woven orthogonally to each other into a plate-like woven structure such that the element wires successively and periodically distribute at all possible positions between opposite surfaces of said plate-like woven structure in a direction of thickness thereof along a weaving direction of the element wires.

2.      A plate-like woven-wire structure accorrding to Claim 1, wherein a percentage of voids in the direction of thickness of said plate-like woven structure is not higher than 25%.

3.      A plate-like woven-wire structure according to Claim 1, wherein the element wires each comprises a single metal core and said coating film is made of an insulative material.

4.      A plate-like woven-wire structure according to Claim 1, wherein the element wires each comprises a single metal core and said coating film is made of a metal different from the metal core material.

5.      A plate-like woven-wire structure according to Claim 1, wherein the element wires each comprises a single metal core, and said coating film comprises a first film on the metal core surface, made of a metal different from the metal core material and a second film on the first film, made of an insulative material.

6.      A plate-like woven wire structure according to Claim 1, wherein each of the element wires is a litz wire including a plurality of separately insulated thin metal cores woven together so that each of said metal cores successively takes up all possible positions in the cross section of the entire wire.

7.      A plate-like woven-wire structure according to Claim 1, wherein the element wires each comprises a single metal core having a diameter less than twice of a skin depth of the metal.

8.      A plate-like woven-wire structure according to Claim 1, wherein said first and second groups of element wires each comprises a plurality of sets each having n element wires, and any one of the n element wires in each set sequentially crosses other element wires in a weaving direction of the element wires.

9.      A woven-wire solid plate comprising:

        first and second groups of element wires (16-1, 16-2) each including at least one metal core (14), an outer periphery of the metal core being covered with a coating film (15) of a material having a higher resistivity than a material of the metal core;

said first and second groups of element wires being woven orthogonally to each other into a plate-like woven structure such that the element wires successively and periodically distribute at all possible positions between opposite surfaces of said plate-like woven structure in a direction of thickness thereof along a weaving direction of the element wires,

said plate-like woven structure being press-formed into a solid plate having substantially flat and continuous opposing surfaces and having the element wires closely packed in any thicknesswise section.

10.    A woven-wire solid plate according to Claim 9, wherein the element wires each comprises a single metal core and said coating film is made of an insulative material.

11.    A woven-wire solid plate according to Claim 9, wherein the element wires each comprises a single metal core and said coating film is made of a metal different from the metal core material.

12.    A woven-wire solid plate according to Claim 9, wherein the element wires each comprises a single metal core, and said coating film comprises a first film on the metal core surface, made of a metal different from the metal core material and a second film on the first film, made of an insulative material.

13.      A woven-wire solid plate according to Claim 9, wherein each of the element wires is a litz wire including a plurality of separately insulated thin metal cores woven together so that each of said metal cores successively takes up all possible positions in the cross section of the entire wire.

14.      A woven-wire solid plate according to Claim 9, wherein the element wires each comprises a single metal core having a diameter less than twice of a skin depth of the metal.

15.      A woven-wire solid plate according to Claim 9, wherein said first and second groups of element wires each comprises a plurality of sets each having n element wires, and any one of the n element wires in each set sequentially crosses other element wires in a weaving direction of the element wires.

16.      A magnetic bubble memory device comprising:

         a parallelpiped core (32) made of a magnetic material having windings (30-1, 30-2, 31-1, 31-2) wound at four positions such that opposing windings are parallel to each other;

         a magnetic bubble memory chip (33) arranged in a space defined by said core;

         a wiring board on which said chip is mounted;

         a shielding conductive case (35) surrounding said core, said chip and said wiring board, said shielding conductive case being formed by a woven structure of first and second groups of element wires (3-1, 3-2) each including at least one metal core, an outer periphery of the metal core (1) being covered with a coating film (2) of a material having a higher resistivity than a material of the metal core;

said first and second groups of element wires being woven orthogonally to each other into a plate-like woven structure such that the element wires successively and periodically distribute at all possible positions between opposite surfaces of said plate-like woven structure in a direction of thickness thereof along a weaving direction of the element wires.

17. A magnetic bubble memory device according to Claim 16, wherein said plate-like woven structure is a solid plate having the element wires closely packed therein.

18. A magnetic bubble memory device according to Claim 16, wherein said plate-like woven structure has voids between the element wires.

19. A magnetic bubble memory device according to Claim 18, wherein a percentage of voids in the direction of thickness of said plate-like woven structure is not higher than 25%.

20. A magnetic bubble memory device according to Claim 16, wherein the element wires each comprises a single metal core and said coating film is made of an insulative material.

21.      A magnetic bubble memory device according to
Claim 16, wherein the element wires each comprises a
single metal core and said coating film is made of a
metal different from the metal core material.

22.      A magnetic bubble memory device according to
Claim 16, wherein the element wires each comprises a
single metal core and said coating film comprises a
first film on the metal core surface, made of a metal
different from the metal core material and a second film
on the first film, made of an insulative material.

23.      A magnetic bubble memory device according to
Claim 16, wherein each of the element wires is a litz
wire inculding a plurality of separately insulated thin
metal cores woven together so that each of said metal
cores successively takes up all possible positions in
the cross section of the entire wire.

24.      A magnetic bubble memory device according to
Claim 16, wherein the element wires each comprises a
single metal core  having a diameter less than twice of
a skin depth of the metal.

25.      A magnetic bubble memory device according to
Claim 16, wherein said first and second groups of
element wires each comprises a plurality of sets each
having n element wires, and any one of the n element
wires in each set sequentiially crosses other element
wires in a weaving direction of the element wires.

0179326

# FIG. 1

# FIG. 2

FIG. 3

FIG. 4          FIG. 5          FIG. 6

FIG. 7

0179326

FIG. 8

FIG. 9

FIG. 10

0179326

## FIG. 11

## FIG. 12

## FIG. 13

0179326

FIG. 14

FIG. 15

FIG. 16

FIG. 17

at $f = f_1$

R

42

R1

43

R2

0    1    2    3

$t / t_0$

FIG. 18

at $t = t_1$

$10^2$

$R / R_0$

10

44    45    46    47

1

1    10    $10^2$    $10^3$    $10^4$

$f / f_0$

FIG. 19

13    1-2    2-2    12

A ● ── B ●    ● D

⊗
y    ● C

7    1-1    2-1

⟶ x

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | US-A-4 030 892 (MENDELSOHN) <br> * Column 2, lines 30-34 * | 1 | H 05 K 9/00 <br> D 03 D 15/00 |
| A | US-A-4 408 255 (ADKINS) <br> * Column 4, lines 30-34 * | 1 | |
| A,D | FR-A-2 404 890 (IBM) <br> * Page 3, lines 23-35 * | 16 | |
| A | FR-A-2 347 854 (VIBRACHOC) <br> * Page 1, lines 23-27 * | 1 | |

TECHNICAL FIELDS
SEARCHED (Int. Cl.4)

H 05 K
G 11 C
D 03 D

The present search report has been drawn up for all claims

| Place of search | Date of completion of the search | Examiner |
|---|---|---|
| THE HAGUE | 21-01-1986 | TOUSSAINT F.M.A. |

EPO Form 1503 03.82

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document